# EUROPEAN PATENT SPECIFICATION

(11) **EP 1 468 327 B1**
(45) Date of publication and mention of the grant of the patent: **17.10.2007**
(21) Application number: 02791002.5
(22) Date of filing: 29.11.2002
(51) Int. Cl.: G02F 1/1333

(54) **METHOD OF FABRICATING A PLASTIC SUBSTRATE**
VERFAHREN ZUR HERSTELLUNG EINES KUNSTSTOFFSUBSTRATS
PROCEDE DE FABRICATION D'UN SUBSTRAT EN PLASTIQUE

(30) Priority: 29.11.2001 KR 2001075128; 20.11.2002 KR 2002072581
(43) Date of publication of application: 20.10.2004
(73) Proprietor: Daewoo Electronics Service Co., Ltd, Seoul 100-802 (KR)
(72) Inventor: Yi, Seung, Jun, Seoul 130-080 (KR); Choi, Kyung, Hee, Seoul 100-806 (KR); Choi, Do-Hyun 1205-508 Mokdong Shinshigaji Apt., Seoul 158-070 (KR); Im, Seong, Sil 305-104 Kachi-Maul Shinwon Apt., Sungnam-shi Kyonggi-do 463-739 (KR); Byun, Byung, Hyun 415-1101 Seonbi-Maeul Apt., Daejeonkwangyeok-shi 306-778 (KR)
(74) Representative: Turi, Michael
(86) International application number: PCT/KR2002/002252
(87) International publication number: WO 2003/046649

(56) References cited:
- WO-A-00/26973
- JP-A- 9 120 084
- US-A- 5 593 794
- US-A- 5 817 550
- US-A- 6 084 765
- US-B1- 6 284 184
- PATENT ABSTRACTS OF JAPAN vol. 1998, no. 09, 31 July 1998 (1998-07-31) & JP 10 111499 A (OPTREX CORP), 28 April 1998 (1998-04-28)
- PATENT ABSTRACTS OF JAPAN vol. 2003, no. 01, 14 January 2003 (2003-01-14) & JP 2002 268046 A (SUMITOMO BAKELITE CO LTD), 18 September 2002 (2002-09-18)

## Description

### TECHNICAL FIELD

The present invention relates to a fabrication of a plastic display substrate having a barrier characteristic against oxygen and moisture, and more particularly, to a method of fabricating a plastic display substrate having a ultra-thin barrier layer which prevents penetration of oxygen and moisture by forming a barrier layer for securing reliability of a display device and by carrying out thermal treatment on a surface of the barrier layer.

### BACKGROUND ART

Demands of various information oriented society due to developments of information communication technology increase the demand on electronic displays. And, the demanded displays are diversified into portable devices such as a mobile phone, PDA, notebook computer, and the like as well as a monitor, TV, etc. When the electronic display devices are fabricated on substrates according to application of the various kinds of the devices, such characteristics as large size, low product cost, high performance, thin thickness and the like are required for the substrates.

There are various kinds of substrates which are currently used such as a transparent glass or quartz substrate, a transparent plastic substrate, a silicon wafer substrate, a sapphire substrate, and the like. The glass, quartz, silicon wafer, and sapphire substrates in those substrates have widely been used owing to the previously established processes and apparatuses. Yet, a great deal of attention is paid to a plastic substrate which is hardly breakable, conveniently portable, light, and flexible as well as easily manufactured.

Compared to the previous substrates such as the fragile glass substrate, a plastic display substrate is hardly breakable and much lighter. Yet, the plastic display substrate itself has the problem that moisture or oxygen in the air easily penetrates into the substrate. Specifically, in order to be used as a substrate of a display device vulnerable to moisture or oxygen, fabrication of a substrate free from the penetration of moisture or oxygen in the air is the major problem to be settled.

In accordance with the research materials read by Ernst Lueder in Stuttgart University, Germany at IDW (international display workshop) 1999, moisture permeability and oxygen permeability, which are required for using a plastic substrate for a display device, for LCD should satisfy 0.1g/m²·day (moisture) and 0.1ml/m² day (0.1cc/m²·day) (oxygen), respectively. Moreover, in case of an organic electroluminescent display device including a light-emitting material specifically vulnerable to moisture, 10-4~10⁻⁶g/m²·day (moisture) of the moisture permeability and 10⁻⁴ ~ 10⁻⁶ ml/m² day (10⁻⁴ ~ 10⁻⁶CC/m²·day) (oxygen) of the oxygen permeability, which are pretty low, are required.

In order to overcome the above problem, many efforts are made to study various methods for forming a barrier layer, which enables to prevent the penetration of oxygen and moisture, on a plastic substrate. And, material fields in the research approach are mainly classified into three categories including a first case of using a polymer material, a second case of using an inorganic material, and a third case of using both of the polymer and inorganic materials by blending.

Meanwhile, when the barrier layer is formed of a single layer of a single kind, it is unable to satisfy the barrier characteristic against moisture or oxygen. Hence, many efforts are made to study a method of using multi-layered barrier layers or a method of forming a barrier layer including multi-layers by alternating polymer and inorganic materials. In U.S. Patent No. 6,106,933 paying attention to the fact that polarity of moisture or oxygen is relatively big, a polyethylene film having hydrophobic property opposite to that of moisture or oxygen is laminated on a surface of a plastic substrate to form a barrier layer. Yet, the corresponding result for moisture is <1.5g/m²·day and that for oxygen is <45cc/m²·day. And, both of the results greatly fail to meet the requirements for an organic electroluminescent display device such as 10⁻⁴~10⁻⁶g/m²·day (moisture) and 10⁻⁴~10⁻⁶ml/m² day (10⁻⁴~10⁻⁶cc/m²·day) (oxygen). Therefore, modification is greatly needed to form a barrier layer having a hydrophobic polymer material laminated on a plastic substrate to be used as a substrate for an organic electroluminescent display device.

On the other hand, in case of a hybrid type having polymer and inorganic material blended with each other, as taught in U.S. Patent No. 5,441,816, U.S. Patent No. 5,415,921, U.S. Patent No. 5,426,131, or the like, a film is prepared to prevent penetration of moisture and oxygen by blending a material selected from the group consisting of polyvinylchloride, tin stabilizer, calcium stearate, butylacrylate rubber graft copolymer, and the like with TiO₂, coating the blended materials thereon, and hardening the coated materials by UV rays.

Besides, in case of using an inorganic substance only as a material of a barrier layer according to U.S. Patent No. 5,508,075, U.S. Patent No. 5,532,063, IDW' 99 (by Ernst Lueder, pp215~pp218), 11^{th} FPD manufacturing conference, E1 section (pp17, Tokyo, Japan), etc., a silicon based insulating material such as SiO₂, SiNₓ (or Si₃N₄), Si+SiO₂, and SiOₓN_{y} or Ta₂O₅ is used as the material. In this case, a single-layered material is used or two kinds of the materials are stacked alternately to be used. Specifically, in 11^{th} FPD manufacturing conference, E1 section, pp17, Tokyo, Japan, a SiOₓN_{y} layer is formed 100-2_00nm thick by sputtering as a barrier layer. The best moisture permeability of the layers is <1.5g /M2 -day which fails to meet the requirement of 10-4∼10⁻⁶g/m²·day(moisture) sufficiently, whereby modification is needed.

Finally, in accordance with U.S. Patent No. 5,487,940, U.S. Patent No. 5,593,794, U.S. Patent No. 5,607,789, and U.S. Patent No. 5,725,909, a method of forming a barrier layer on a plastic substrate enabling to prevent the penetration of oxygen and moisture includes the steps of forming a barrier layer of one layer using an inorganic or polymer material and forming another barrier layer using an inorganic or polymer material alternately. Specifically, the method includes the steps of forming a polymer (or inorganic) layer, forming an inorganic (or polymer) layer on the polymer layer, and repeating the previous steps several times to form a barrier layer of multi-layers. In this case, the polymer layer is formed by liquid phase printing, dipping, or polymerization by depositing monomers of polymer selected from the group consisting of cross-linked acrylate polymer, polyvinylalcohol cross-linked with aldehyde, polyfluorocarbon polymer, etc. In JP 10111499 A silicon-based barrier lagers are formed on each side of a plastic substrate. The material is then fired at a temperature of ±30°C of the glass transition point of the plastic substrate. The features knows in combinaison from JP 10111499A are included in the preamble of appended claim 1.

In case of forming a barrier layer with 1.02 µm (0.04mil) cross-linked polyvinylalcohol on a polypropylene film according to U.S. Patent No. 5,487,940, permeability (3.1x10⁻⁵ml/cm²day) (0.02cc/100in²·day) that oxygen penetrates the substrate is reduced 30 times less than that (>0.23ml/cm²·day)(>150cc/100in²·day) of the case without forming the barrier layer. Moreover, the inorganic material used as a barrier layer material is selected from the group consisting of SiO₂, Al₂O₃, SiNₓ, metal such as Al and the like, glass mixture (SnO:SnF₂:PbO:P₂O₅=32:37:8:23), etc. Specifically, in case of forming at least three alternating barrier layers using fluorocarbon polymer having a hydrophobic property as a polymer material and SiNₓ or SiO₂ as an inorganic material according to U.S. Patent No. 5,593,794, (polymer/SiNₓ)x3 shows <0.01mL/cm².day (<8cc/100in²·day) but (polymer/SiO₂)x3 does <0.37ml/cm².day (<240cc/100in²·day). Hence, SiNₓ has a moisture-penetration preventing characteristic which is about 30 times superior to that of SiO₂. Compared to the case of forming the barrier layer using the hybrid layer or the polymer or inorganic layer only, the case of using such multi-layers has excellent characteristics relatively but needs to form a plurality of layers using inorganic and polymer materials alternately to increase product cost due to the elongated forming time.

Hence, in order to apply the case to the practical mass production, a scheme of reducing the forming time remarkably or bringing a maximum effect with a minimum layer is required.

As mentioned in the above explanation, only the case of stacking the barrier layers by repeating the respective layers at least three times alternately using the polymer and inorganic layers (specially, metal or silicon based insulating materials) results in the excellent penetration preventing characteristics against moisture and oxygen. The more the layers are stacked, the more the penetration preventing characteristics increase. Yet, the forming time is elongated to increase the product cost as well.

Unfortunately, the plastic substrate having the barrier layer according to the related art has the following problems.

In order to cut off moisture or oxygen penetrating through a plastic substrate completely, stacking resin and inorganic layers should be repeated at least three times. Specifically, it is insufficient to attain the demanded moisture permeability unless the metal component is used as the inorganic layer. Since the substrate should be transparent to be used for a display substrate, this method cannot be applied to the fabrication of the plastic substrate. Moreover, in order to form the barrier layer of the multi-stacked structure, the process time increases, the process becomes complicated, and the product cost increases.

### DISCLOSURE OF THE INVENTION

Accordingly, the present invention is directed to a method of fabricating a plastic substrate that substantially obviates one or more of the problems due to limitations and disadvantages of the related art.

An object of the present invention is to provide a method of fabricating a transparent plastic display substrate having a barrier layer enabling to prevent the penetration of oxygen and moisture with small thickness without causing damage on a substrate by forming a barrier layer of a silicon based insulating material and carrying out thermal treatment on a surface of the barrier layer locally in fabricating a plastic substrate applicable to an organic electroluminescent display device.

Additional features and advantages of the invention will be set forth in the description which follows, and in part will be apparent from the description, or may be learned by practice of the invention. The objectives and other advantages of the invention will be realized and attained by the structure particularly pointed out in the written description and claims thereof as well as the appended drawings.

To achieve these and other advantages and in accordance with the purpose of the present invention, as embodied and broadly described, a method of fabricating a plastic display substrate according to the present invention includes the steps defined in Claim 1.

Preferred developements are defined in the appended dependent claims.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
Fig. 1 illustrates a cross-sectional view of a plastic display substrate according to the present invention;
Fig. 2 illustrates a schematic diagram of a laser annealing device according to the present invention;
Fig. 3 illustrates a cross-sectional view of a plastic display substrate according to a first embodiment of the present invention;
Fig. 4 illustrates a cross-sectional view of a plastic display substrate according to a second embodiment of the present invention; and
Fig. 5 illustrates a diagram of a bonding structure of a silicon nitride layer as a barrier layer using a silicon based insulating material.

### BEST MODE FOR CARRYING OUT THE INVENTION

Reference will now be made in detail to the preferred embodiments of the present invention, examples of which are illustrated in the accompanying drawings.

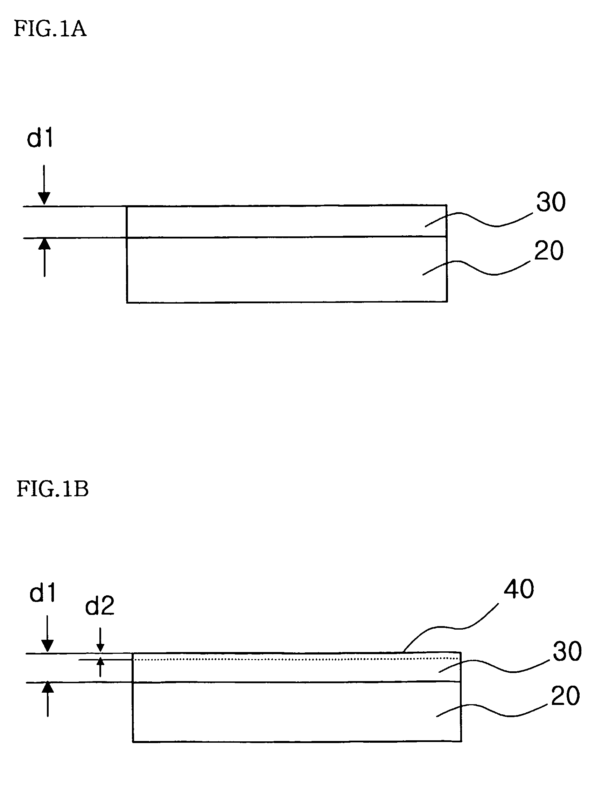

Fig. 1 illustrates a cross-sectional view of a plastic display substrate according to the present invention.

Referring to Fig. 1a, a thin barrier layer 30 of a silicon based insulating material enabling to prevent penetration of external oxygen or moisture is formed on a transparent plastic substrate 20. The barrier layer 30 includes a single layer or plural layers selected from the group consisting of a silicon oxynitride layer (SiOₓN_{y}) and a silicon nitride layer (Si₃N₄ or SiNₓ), and is formed to an initial thickness dl of 100~10,000Å, and more preferably, to 100~3,000Å. The barrier layer 30 is formed by chemical vapor deposition, sputtering, electron beam, or the like.

When the barrier layer 30 is formed by chemical vapor deposition with the silicon based insulating material, a deposition temperature of layer is 25~300°C, an inert gas is used as a carrier gas, SiNₓ uses SiH₄, NH₃, and N₂ as reactive gases, and SiOₓN_{y} uses SiH₄, N₂O, NH₃, and N₂ as reactive gases. When the barrier layer 30 is formed with a silicon based insulating material by sputtering, a deposition temperature of layer is 25~300°C, an inert gas is used as a sputtering gas, and SiNₓ and SiOₓN_{y} use Si₃N₄ and SiON targets, respectively. When reactive sputtering is employed, a silicon target is used and a reactive gas is injected as well as a sputtering gas of inert gas. When SiNₓ is deposited, N₂ gas is injected. When SiOₓN_{y} is deposited, O₂ and N₂ gases are injected.

And, the plastic substrate is formed of a transparent material selected from the group consisting of polyethersulphone (PES), polyethylene terephthalate (PET), polycarbonate (PC), polyethylene (PE), polyethylene naphthenate (PEN), polyolefin, polystyrene (PS), polyvinylchloride (PVC), polyester, polyamide, polynorborene (PNB), polyimide (PI), polyarylate (PAR), and the like.

The silicon based material for forming the barrier layer 30 is silicon oxynitride (SiOₓN_{y}) or silicon nitride (Si₃N₄ or SiNₓ) . Hence, the barrier layer 30 is formed of a single layer or multi-layers of at least two layers which is or are selected from the insulating materials. Moreover, the silicon based insulating inorganic material, resin, and silicon based insulating inorganic material are stacked sequentially to form the barrier layer 30.

Otherwise, the resin, silicon based insulating inorganic material, and resin are sequentially stacked to form the barrier layer 30.

And, a stacked structure of three layers including a resin layer, a silicon based insulating inorganic material layer, and a resin layer is stacked consecutively to form a plurality of the stacked structures of three layers including the resin, silicon based insulating inorganic material, and resin layers.

And, the barrier layer 30 can be formed on a bottom of the transparent plastic substrate 20 as well as a top of the transparent plastic substrate 20 (not shown in the drawing).

Referring to Fig. 1b, thermal treatment is carried out to eliminate defects of the barrier layer 30. Since the barrier layer 30 is stacked by chemical vapor deposition, electron beam deposition, or sputtering instead of thermal growth, a plurality of incomplete bonds between silicon and oxygen or nitrogen are generated. A plurality of dangling bonds generated from the incomplete bonds and porosity bring about the defects of the barrier layer 30. Namely, the defects of the barrier layer 30 provide the paths through which oxygen and moisture pass.

Hence, the defects should be eliminated by thermal treatment.

An annealing temperature to eliminate the defects of the barrier layer 30 consisting of the silicon based compound is about 700~1,100°C. Since it is unable to anneal the plastic substrate failing to be stable at the annealing temperature, local thermal treatment is carried out on a surface of the barrier layer only using an excimer laser so as not to cause damage on the substrate.

Thermal treatment of the barrier layer 30 is carried out by one of Ar₂, Kr₂, Xe₂, ArF, KrF, XeCl, and F₂ excimer lasers. Table 1 shows wavelengths of the respective excimer lasers.

In this case, annealing power of the excimer laser is 10~2,000mJ/cm² and an ambient temperature is under 300°C. And, an instant temperature of annealing the barrier layer 30 is at least 700°C. Besides, the number of the operation of annealing is at least one or more, if necessary.

In the above-explained annealing, one of a pulse excimer layer, a continuous wave oscillation excimer laser, a pulse solid laser, a continuous wave oscillation solid laser is selected to use. For example, when a silicon nitride layer (Si₃N₄ or SiNₓ) is used for a barrier layer, an ArF pulse excimer laser is proper for carrying out local thermal treatment on a surface of the barrier layer without causing damage on a substrate. An absorption coefficient of the silicon nitride layer for the ArF laser, which varies according to deposition conditions, is about 10⁵cm⁻¹, at least 70% energy of the ArF laser is absorbed within 2,000 Å from the surface, and a pulse width of the ArF pulse excimer laser is several tens nanoseconds.

Hence, a temperature of the surface layer is raised instantly up to at least 700°C without causing damage on the substrate.

After annealing, the barrier layer 30 has a highly densified homogeneous layer 40 having a network structure consisting of silicon-oxygen or silicon-nitrogen bonds. And, porosity and hydrogen content, which is bonded to the dangling bonds, of the highly densified homogeneous layer 40 are minimized. A thickness d2 of the highly densified homogeneous layer 40 is formed about 10~2,000Å thick after annealing. Since the network structure is attained and the hydrogen content is reduced, the penetration of moisture and oxygen through the transparent plastic substrate 20 is prevented from outside. Therefore, degradation of a display device using this substrate is prevented.

**[Table 1]**

| Excimer Laser | Wavelength |
|---|---|
| Ar₂ | 126nm |
| Kr₂ | 146nm |
| Xe₂ | 172nm |
| ArF | 193nm |
| XeF | 351nm |
| KrF | 250nm |
| XeCl | 308nm |
| F₂ | 157nm |

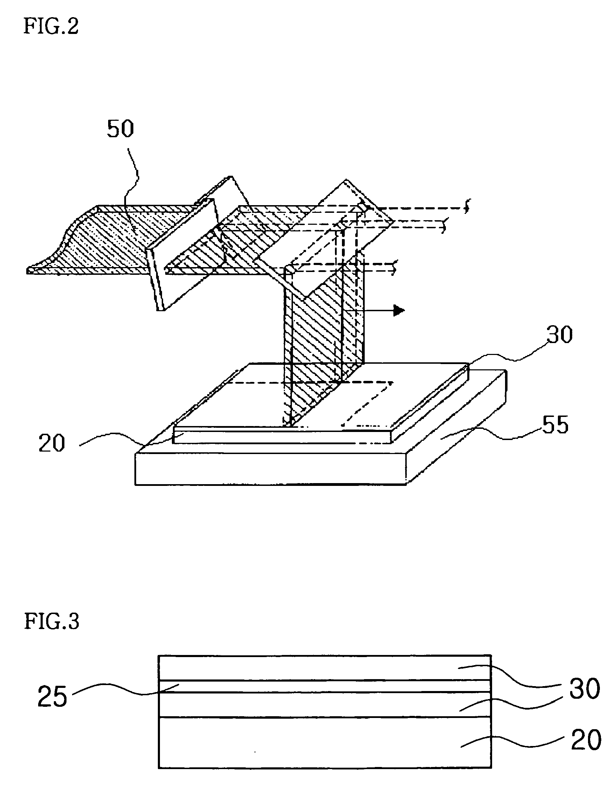

Fig. 2 illustrates a schematic diagram of a laser annealing system according to the present invention.

Referring to Fig. 2, a process of annealing a surface of the barrier layer 30 locally, as prepared in Fig. 1, on the transparent plastic substrate 20 is schematically shown. A highly densified homogeneous layer having shield characteristics against oxygen or moisture is attained by annealing the surface of the barrier layer 30 locally by scanning the transparent plastic substrate 20 having the barrier layer 30 formed thereon with an excimer laser 50. In this case, the transparent plastic substrate 20 is put on a substrate support 55 for laser annealing. When the plastic substrate has a dimension of 370mm x 470mm, the scanning of the excimer laser 50 is carried out for several minutes.

### [First embodiment]

Fig. 3 illustrates a cross-sectional view of a plastic display substrate according to a first embodiment of the present invention.

Referring to Fig. 3, when a barrier layer is formed on one side of a transparent plastic substrate to remove very small amount of moisture, oxygen, and the like penetrating through the transparent plastic substrate, a desiccant layer 25 is formed between two barrier layers 30 on the transparent plastic substrate 20. In this case, the desiccant layer 25 is formed of a metal oxide layer having excellent moisture absorption and adsorption characteristics such as Al₂O₃, CaO, Y₂O₃, MgO, or the like and resin such as polyurea or the like to the thickness of 50~10,000Å, and more preferably, 100~2,000Å.

### [second Embodiment]

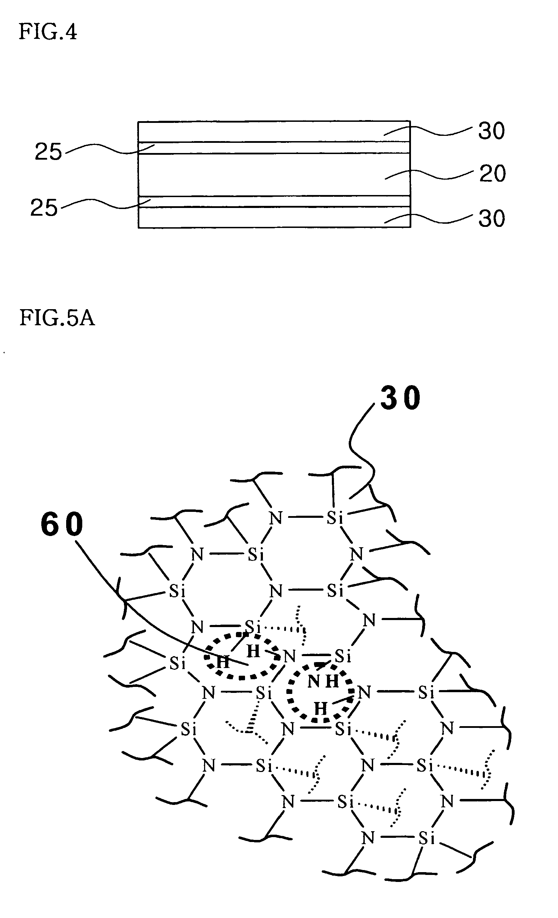

Fig. 4 illustrates a cross-sectional view of a plastic display substrate according to a second embodiment of the present invention.

Referring to Fig. 4, when barrier layers 30 are formed respectively on both sides, i.e. top and bottom, of a transparent plastic substrate 20 to remove very small amount of moisture, oxygen, and the like penetrating through the transparent plastic substrate, desiccant layers 25 are formed between the barrier layer 30 and the top of the transparent plastic substrate 20 and between the other barrier layer 30 and the bottom of the transparent plastic substrate 20. In this case, each of the desiccant layers 25 is formed of a metal oxide layer having excellent moisture absorption and adsorption characteristics such as Al₂O₃, CaO, Y₂O₃, MgO, or the like and resin such as polyurea or the like to the thickness of 50~10,000Å, and more preferably, 100~2,000Å.

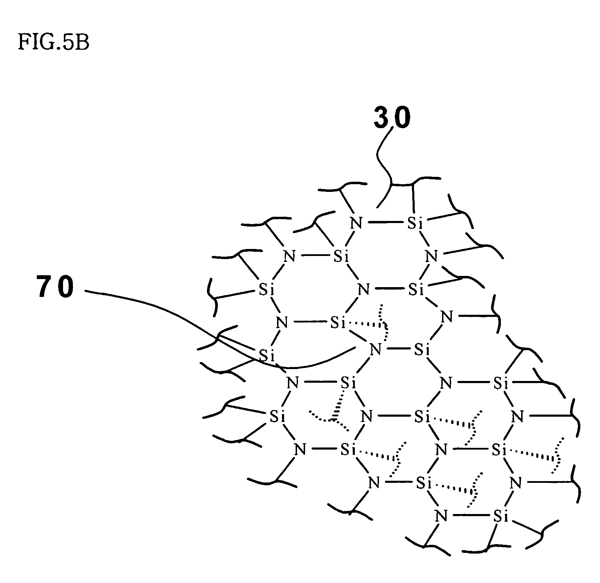

Fig. 5 illustrates a diagram of a bonding structure of a silicon nitride layer as a barrier layer using a silicon based insulating material.

Referring to Fig. 5a, since a barrier layer 30 formed of a silicon based insulating material is stacked not by thermal growth but by chemical vapor deposition or sputtering, silicon and nitrogen fail to be bonded to each other completely. Hence, a plurality of dangling bonds 60 exist and a property of the layer becomes defective. Besides, the dangling bonds 60 are bonded to hydrogen to increase the hydrogen content in the barrier layer 30. The dangling bonds 60 and the porous property of the layer lead to the penetration of oxygen and moisture.

Referring to Fig. 5b, shown is a bonding structure of a barrier layer 30 after local annealing carried out on a surface of the barrier layer 30 using an excimer laser. Local annealing breaks down the bond between the dangling bond 60 and hydrogen at a surface of the barrier layer, and a bond 70 between silicon and nitrogen is achieved to eliminate the dangling bonds 60. The elimination of the dangling bonds 60 reduces the hydrogen content and minimizes the porosity of the barrier layer 30. Therefore, a homogeneous barrier layer enabling to prevent the penetration of oxygen and moisture is prepared.

Moreover, in case of a single-layered layer, micro defects such as pinhole and the like on a surface of a film can be cured by carrying out at least one more overall process of barrier layer formation and laser annealing, whereby a homogeneous barrier layer can be prepared.

Moreover, in the above-explained description, sequentially stacked to form the barrier layer 30 are a silicon based inorganic material on which the overall process of layer formation and laser annealing is carried out, a resin layer, and another silicon based inorganic material on which the overall process of layer formation and laser annealing is carried out. Or, sequentially stacked to form the barrier layer 30 are a resin layer, a silicon based inorganic material on which the overall process of layer formation and laser annealing is carried out, and a resin layer.

Besides, a barrier layer 30 and a highly densified homogeneous layer 40 are formed on top and bottom of a plastic substrate 20, thereby enabling to maximize the preventing effect against moisture and oxygen.

The above-described method of forming the barrier layer preventing the penetration of moisture and oxygen is not limited to the case of the transparent plastic substrate for display but covers the case of forming a barrier layer cutting off moisture and oxygen in the air using the purpose and method similar to the present invention.

### INDUSTRIAL APPLICABILITY

The method of fabricating the plastic display substrate according to the present invention has the following effects or advantages.

The method according to the present invention anneals the surface of the barrier layer locally consisting of Si-O or Si-N bonds without causing any damage on the transparent plastic substrate to form the homogeneous layer minimizing the hydrogen content and the porosity, thereby enabling to prevent the degradation of the display device by suppressing the penetration of external oxygen, moisture, and the like.

Moreover, multi-layers of at least 6-7 stacked layers are required for forming the barrier layer enabling to cut off the externals oxygen and moisture by sputtering, electron beam deposition, or chemical vapor deposition according to the related art. However, the local laser annealing process of the thin barrier layer formed by the method according to the present invention takes several minutes only, thereby enabling to reduce a process time as well as to minimize the number of the stacked layers.

Besides, in order to form the barrier layer enabling to cut off the external oxygen and moisture by sputtering, electron beam deposition, or chemical vapor deposition according to the related art, the thickness of at least 2,000Å is required. SiNₓ has a great prevention characteristic against the penetration of moisture or oxygen and has a high surface hardness to resist a surface scratch. Yet, SiNₓ has a low transmittance to limit the scope of application as a barrier layer on a transparent plastic substrate for display. The present invention reduces the thickness of the SiNₓ layer remarkably and modifies the layer property by local annealing, thereby settling the problem of transmittance as well as minimizing the number of the barrier layers. Therefore, the present invention enables to reduce the process time and the product cost remarkably. Moreover, the present invention needs not to form an additional hard coating layer for the fabrication of the plastic substrate except the barrier layer to increase the surface hardness.

While the present invention has been described and illustrated herein with reference to the preferred embodiments thereof, it will be apparent to those skilled in the art that various modifications and variations can be made therein without departing from the scope of the invention. Thus, it is intended that the present invention covers the modifications and variations of this invention that come within the scope of the appended claims.

## Claims

1. A method of fabricating a plastic display substrate, comprising the steps of:
(a) forming one or more silicon based barrier layers (30) on a base layer which includes a transparent plastic substrate (20); and
(b) annealing said one or more barrier layers,
**characterized in that** only a surface layer (40) of said one or more silicon based barrier layers is annealed.

2. The method of claim 1, wherein the base layer further includes a desiccant layer (25) arranged on the transparent plastic substrate (20).

3. The method of claim 2, wherein a silicon based layer (30) is formed on both sides of the base layer.

4. A method of fabricating a plastic display substrate according to claim 1, **characterized in that** step (a) includes the steps of:
(a1) forming a first barrier layer (30) on the base layer;
(a2) forming a desiccant layer (25) on the first barrier layer
(a3) forming a second barrier layer (30) on the desiccant layer (25);
and **in that** step (b) includes the step of annealing only a surface layer (40) of the first or the second barrier layer (30) or annealing only a surface layer (40) of the first and the second barrier layer (30).

5. The method of claims 2 to 4, wherein a material constituting the desiccant layer (25) is selected from the group consisting of Al₂O₃, CaO, Y₂O₃, MgO, and polyurea.

6. The method of claims 1 to 5, wherein the one or more barrier layers (30) consist of a single layer or plural layers formed of a material selected from the group consisting of silicon oxynitride and silicon nitride.

7. The method of claims 1 to 6, wherein the step of annealing is performed by using one of a pulse excimer laser, a continuous wave oscillation excimer laser, a pulse solid state laser, and a continuous wave oscillation solid state laser, an annealing power thereof is 10mJ/cm²~2,000mJ/cm², and an ambient temperature is below 300°C.

8. The method of claims 1 or 7, wherein the step of annealing is performed by using one of Ar₂, Kr₂, Xe₂, ArF, KrF, XeCl, and F₂ excimer lasers.

9. The method of claims 1 to 4, wherein each barrier layer has a structure of three stacked layers comprising a first silicon based insulating inorganic material layer, a resin layer, and a second silicon based insulating inorganic material layer.

10. The method of claims 1 to 4, wherein each barrier layer has a plurality of stacked structures each of which comprises three stacked layers having a first resin layer, a silicon based insulating inorganic material layer, and a second resin layer.

## Patentansprüche

1. Verfahren zur Herstellung eines Kunststoffanzeigen-Substrats, umfassend die Schritte:
(a) Bilden einer oder mehrerer Barriereschichten (30) auf Silicium-Basis auf einer Basis-Schicht, welche ein transparentes Kunststoffsubstrat (20) einschließt; und
(b) Glühen der einen oder mehreren Barriereschichten,
**dadurch gekennzeichnet, dass** nur eine Oberflächenschicht (40) der einen oder mehreren Barriereschichten auf Silicium-Basis geglüht wird.

2. Verfahren nach Anspruch 1, bei dem die Basisschicht weiter eine Trocknungsmittelschicht (25) einschließt, die auf dem transparenten Kunststoffsubstrat (20) angeordnet ist.

3. Verfahren nach Anspruch 2, bei dem eine Schicht auf Silicium-Basis (30) auf beiden Seiten der Basisschicht gebildet wird.

4. Verfahren zur Herstellung eines Kunststoffanzeigen-Substrats nach Anspruch 1, **dadurch gekennzeichnet, dass** der Schritt (a) die folgenden Schritte einschließt:
(a1) Bilden einer ersten Barriereschicht (30) auf der Basisschicht;
(a2) Bilden einer Trocknungsmittelschicht (25) auf der ersten Barriereschicht;
(a3) Bilden einer zweiten Barriereschicht (30) auf der Trocknungsmittelschicht (25);
und **dadurch**, dass Schritt (b) den Schritt des Glühens nur einer Oberflächenschicht (40) der ersten oder der zweiten Barriereschicht (30) oder des Glühens nur einer Oberflächenschicht (40) der ersten und der zweiten Barriereschicht (30) einschließt.

5. Verfahren nach den Ansprüchen 2 bis 4, bei dem ein Material, welches die Trocknungsmittelschicht (25) bildet, ausgewählt ist aus der Gruppe bestehend Al₂O₃, CaO, Y₂O₃, MgO und Polyharnstoff.

6. Verfahren nach den Ansprüchen 1 bis 5, bei dem die eine oder mehreren Barriereschichten (30) aus einer einzigen Schicht oder mehreren Schichten bestehen, die aus einem Material gebildet sind, das ausgewählt ist aus der Gruppe bestehend aus Siliciumoxynitrid und Siliciumnitrid.

7. Verfahren nach den Ansprüchen 1 bis 6, bei dem der Schritt des Glühens unter Verwendung eines Puls-Excimer-Lasers, eines Excimer-Lasers mit kontinuierlicher Wellenoszillation, eines gepulsten Festkörper-Lasers oder eines Festkörper-Lasers mit kontinuierlicher Wellenoszillation durchgeführt wird, dessen Glühleistung 10 mJ/cm² - 2000 mJ/cm² beträgt, und die Umgebungstemperatur unter 300 °C liegt.

8. Verfahren nach den Ansprüchen 1 oder 7, bei dem der Schritt des Glühens unter Verwendung eines Ar₂-, Kr₂-, Xe₂-, ArF-, KrF-, XeCl- oder F₂-Excimer-Lasers durchgeführt wird.

9. Verfahren nach den Ansprüchen 1 bis 4, bei dem jede Barriereschicht eine Struktur von 3 gestapelten Schichten aufweist, welche eine erste Schicht aus isolierendem anorganischem Material auf Silicium-Basis, eine Harzschicht und eine zweite Schicht aus isolierendem anorganischem Material auf Silicium-Basis umfassen.

10. Verfahren nach den Ansprüchen 1 bis 4, bei dem jede Barriereschicht eine Mehrzahl von gestapelten Strukturen aufweist, von denen jede drei gestapelte Schichten mit einer ersten Harzschicht, einer Schicht aus isolierendem anorganischem Material auf Silicium-Basis und eine zweite Harzschicht aufweist.

## Revendications

1. Méthode de fabrication d'un substrat d'affichage en plastique, comprenant les étapes consistant à :
(a) former une ou plusieurs couches de barrière à base de silicium (30) sur une couche de base qui comprend un substrat en plastique transparent (20) ; et à
(b) recuire lesdites une ou plusieurs couches de barrière,
**caractérisée en ce que** seule une couche de surface (40) desdites une ou plusieurs couches de barrière à base de silicium est recuite.

2. Méthode selon la revendication 1, dans laquelle la couche de base comprend en outre une couche déshydratante (25) agencée sur le substrat en plastique transparent (20).

3. Méthode selon la revendication 2, dans laquelle une couche à base de silicium (30) est formée sur les deux côtés de la couche de base.

4. Méthode de fabrication d'un substrat d'affichage en plastique selon la revendication 1,
**caractérisée en ce que** l'étape (a) comprend les étapes consistant à :
(a1) former une première couche de barrière (30) sur la couche de base ; à
(a2) former une couche déshydratante (25) sur la première couche de barrière ; à
(a3) former une seconde couche de barrière (30) sur la couche déshydratante (25) ; et **en ce que** l'étape (b) comprend l'étape consistant à recuire uniquement une couche de surface (40) de la première ou de la seconde couche de barrière (30) ou à recuire uniquement une couche de surface (40) de la première et de la seconde couches de barrière (30).

5. Méthode selon les revendications 2 à 4, dans laquelle un matériau constituant la couche déshydratante (25) est choisi dans le groupe composé de Al₂O₃, CaO, Y₂O₃, MgO et la polyurée.

6. Méthode selon les revendications 1 à 5, dans laquelle les une ou plusieurs couches de barrière (30) sont composées d'une seule couche ou de plusieurs couches formées d'un matériau choisi dans le groupe composé de l'oxynitrure de silicium et du nitrure de silicium.

7. Méthode selon les revendications 1 à 6, dans laquelle l'étape de recuit s'effectue au moyen de l'un d'un laser excimère à impulsions, d'un laser excimère à oscillation en régime d'ondes entretenues, d'un laser à solide à impulsions et d'un laser à solide à oscillation en régime d'ondes entretenues, la puissance de recuit de celui-ci étant de 10 mJ/cm² à 2000 mJ/cm² et la température ambiante étant inférieure à 300 °C.

8. Méthode selon les revendications 1 ou 7, dans laquelle l'étape de recuit s'effectue au moyen de l'un des lasers excimères Ar₂, Kr₂, Xe₂, ArF, KrF, XeCl et F₂.

9. Méthode selon les revendications 1 à 4, dans laquelle chaque couche de barrière possède une structure de trois couches empilées comprenant une première couche de matière inorganique isolante à base de silicium, une couche de résine et une seconde couche de matière inorganique isolante à base de silicium.

10. Méthode selon les revendications 1 à 4, dans laquelle chaque couche de barrière possède plusieurs structures empilées, chacune d'elles comprenant trois couches empilées ayant une première couche de résine, une couche de matière inorganique isolante à base de silicium et une seconde couche de résine.
